## Europäisches Patentamt
## European Patent Office
## Office européen des brevets

(19)

(11) Publication number:

**0 078 371**
A2

(12)

# EUROPEAN PATENT APPLICATION

(21) Application number: 82107378.0

(22) Date of filing: 13.08.82

(51) Int. Cl.³: **G 11 C 19/08**

(30) Priority: 29.10.81 US 316250

(43) Date of publication of application: 11.05.83
Bulletin 83/19

(84) Designated Contracting States: DE FR GB

(71) Applicant: International Business Machines Corporation,
Armonk, N.Y. 10504 (US)

(72) Inventor: Bogholtz, William Ernest, 11E Alpine Drive,
Wappingers Falls New York 12590 (US)
Inventor: Sanders, Ian Lewis, 811 Kingfisher Terrace,
Sunnyvale California 94087 (US)

(74) Representative: Chaudhry, Mohammad Saeed, IBM
United Kingdom Patent Operations Hursley Park,
Winchester Hants, S021 2JN (GB)

(54) An ion-implanted contiguous-disk bubble device.

(57) This invention relates to an ion-implanted contiguous-
disk bubble device including a major loop (12), folded minor
loops (18A, 18B, 18C) and transfer elements (28A, 28B, 28C)
positioned between the major loop (12) and the folded ends
(22A, 22B, 22C) of the minor loops. In a preferred embodi-
ment, the transfer element (28A) has a merge portion (32A)
adjacent and in spaced relation to the folded end (22A) of
the minor loop (18A). In a second embodiment the transfer
element is connected directly to the folded end portion of the
minor loop. Preferably the periodicity in the major loop is
about times the periodicity of the minor loop.

AN ION-IMPLANTED CONTIGUOUS-DISK BUBBLE DEVICE    0078371

This invention relates to ion-implanted contiguous-disk bubble devices
and more particularly to a folded minor loop arrangement.

Folded minor loops in major-minor loop bubble devices using gap tolerant
permalloy propagation elements, that is, asymmetric chevrons, have been
described in the patent to Dimyan et al, No. US 4,176,404.  The minor
loops are structured such that the areas closest to the transfer gates
have a larger circuit period than in the storage section of the minor
loops  which has the folded portion.  The major loop periodicity is
about twice the periodicity of the storage section of the minor loops.
In general, permalloy propagation elements do not lend themselves to a
major loop period that is greater than twice the minor loop period,
thereby making transfer of bubbles from adjacent major loop elements to
adjacent minor loops difficult.  The purpose of the folded loop portions
is to enhance the storage density and is not directly involved with
improving the transfer of bubbles from the write major loop to the minor
loops.  A folded closed loop propagation pattern of permalloy elements
has also been employed for bubble lattices and is described in the
patent to Brown, 4,172,290.  However, this device does not have a
major-minor loop architecture.  Both of these folded loop bubble devices
require permalloy propagation elements.

Whereas the permalloy propagation elements in the bubble devices
described above form the propagation paths or tracks and are positioned
on top of the bubble supporting material, ion-implanted contiguous-disk
bubble devices employ tracks formed by ion-implanting a pattern in the
bubble supporting material.  Examples of typical contiguous disk minor
loops are disclosed in US Patent 4,142,250.  These contiguous-disk
devices have minor loops that are straight, that is, they are not
folded.  When contiguous-disk devices employing the straight minor loops
are scaled down, the magnetic fields due to the current in the
conductors interfere with the propagation of bubbles in the minor loops.
As a result, rigid limitations are imposed on transfer gate design in
both the conductor placement and the ion-implanted pattern geometry.

1

According to the invention there is provided an ion-implanted contiguous-disk bubble device comprising a write major loop and a minor loop characterised in that said minor loop includes propagation sections and a folded end portion in spaced relation to said major loop and wherein bubbles transfer from said major loop to said folded end portion.

In a preferred embodiment, the transfer element has a merge portion adjacent and in spaced relation to the folded end of the minor loop. The use of a transfer element having a separate merge portion has the advantage that existing bubbles in the minor loop do not propagate around the transfer element, thereby protecting these existing bubbles in the minor loop from the influence of the transfer conductor magnetic fields. In a second embodiment, the transfer element is connected directly to the folded end portion of the minor loop. In another preferred embodiment, the periodicity in the major loops is about four times the periodicity of the minor loop. Such a periodicity is desirable since it permits bubbles to be transferred from adjacent locations in the write major loop to adjacent minor loops. Similarly, bubbles can be transferred from adjacent minor loop transfer out ends to adjacent locations on the read major loop.

The invention will now be described by way of example with reference to the accompanying drawings in which:-

FIGURE 1 is a top view of one embodiment of a folded minor loop arrangement in accordance with this invention; and

FIGURE 2 is a top view of a second embodiment of a folded loop arrangement in accordance with this invention.

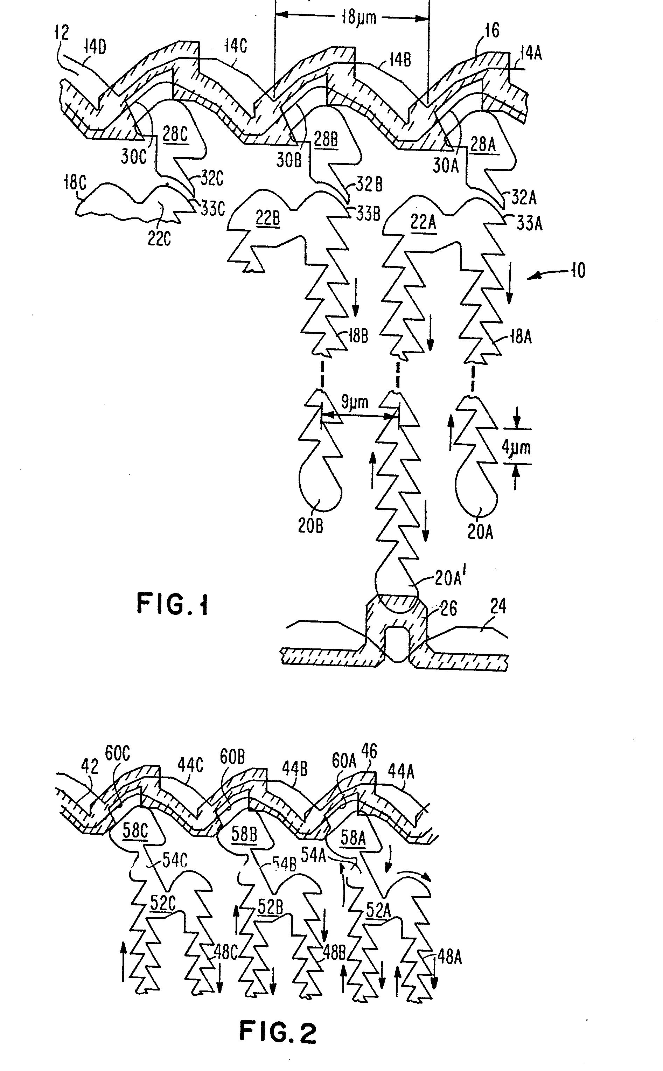

As shown in Figure 1, in a preferred embodiment the contiguous-disk bubble device 10 includes a write major loop 12 consisting of sections 14A, 14B, 14C and 14D. The periodicity of sections 14A-D in the major loop 12 is about four times the periodicity of the minor loop sections in the storage area. A specific example as set forth in Fig. 1 shows

2

the periodicity of minor loop 18A is 4μm and the spacing between the centres of adjacent minor loop 18A and 18B sections is 9μm. The periodicity of major loop section 14B is 18μm. A periodicity of four times is desirable because it permits bubbles to be transferred from adjacent locations or sections in the write major loop to adjacent minor loops. Positioned over the write major loop 12 is a conductor 16. The design of the conductor is not critical to the implementation of this invention. The extra space in the transfer gate area provided by the larger write major loop period allows the use of larger conductors and less critical alignment between the conductor and the major loop pattern. Since this invention provides flexibility in transfer conductor placement, any conductor design consistent with good transfer operation can be used.

Minor loops 18A, 18B and 18C contain end portion 20A and transfer out end portion 20A', and end portion 20B respectively. In accordance with this invention, the minor loops 18A, B and C have folded minor loop portions 22A, 22B and 22C respectively. The minor loop transfer out end portion 20A' is positioned near read major loop path 24. A conductor 26 is positioned to assist switching from element 20A' to major loop read path 24. The read major loop 24 has a periodicity of about four times the minor loop, thereby permitting bubbles from adjacent minor loops transfer out ends to be transferred to adjacent locations on the read major loop 24. The large read major loop period provides similar advantages to those described for the large write minor loop period. Minor loop end portions 20A and 20B are positioned a distance away from the read major loop 24 that is sufficient to prevent magnetic fields from conductor 26 from adversely affecting the movement of bubbles around portions 20A and B.

Positioned between the write major loop 12 and the folded minor loop portions 22A, B and C are transfer elements 28A, B and C respectively. Bubbles positioned on portions 30A, B and C on write major loop sections 14A, B and C respectively propagate to the adjacent surface of transfer elements 28A, B and C respectively when current is passed through conductor 16. With the application of a rotating magnetic field, the

3

0078371

bubble propagate in a clockwise direction around transfer elements 28A,
B and C to the merge portions 32A, B and C respectively. The bubble
then transfers to the folded minor loop end portions 22A, B and C that
are adjacent merge portions 32A, B and C respectively. The bubbles
continue to propagate along the minor loops 18A and B in the direction
shown. Bubbles propagating around the minor loops 18A, B and C
propagate around the folded end portions 22A, B and C respectively and
through the merge channels 33A, B and C respectively. In this way,
bubbles propagating around the minor loops 18A, B and C are kept away
from magnetic fields generated by currents in conductor 16 so that
interaction effects do not lower the operating margin of the bubble
device.

As shown in Figure 2, in a second embodiment the contiguous-disk bubble
device 40 includes a write major loop 42 consisting of sections 44A, 44B
and 44C. The periodicity in the major loop 42 is about four times the
periodicity of the minor loops in the storage area. Positioned over the
write major loop 42 is a conductor 46. In accordance with this
invention, the minor loops 48A, 48B and 48C have folded minor loop
portions 52A, 52B and 52C respectively. In this embodiment the folded
minor loop end portions 52A, 52B and 52C are connected directly to
transfer elements 58A, 58B and 58C respectively. Bubbles positioned on
portions 60A, 60B and 60C on write major loop elements 44A, 44B and 44C
respectively propagate to the adjacent surface of transfer elements 58A,
58B and 58C respectively when current is passed through the conductor
46. With the application of a rotating magnetic field, the bubbles
propagate in a clockwise direction around the transfer elements 58A, B
and C to the folded minor loop end portions 52A, B and C respectively,
and continue to propagate along the minor loops 48A, B and C in the
direction shown.

Bubbles propagating around minor loops 52A, 52B and 52C propagate around
the transfer element 58A as shown. In this embodiment the bubbles are
not kept away from the magnetic fields generated by the currents in
conductor 46. However, because the major loop period is large, there is
sufficient space between neighbouring transfer regions, 60A, B and C to

4

SA9-81-013

0078371

58A, B and C respectively, to allow an increase in the size of the minor loop sections 54A, B and C. Increasing the size of sections 54A, B and C enables existing bubbles in the minor loops to be maintained at a greater distance from the transfer conductor than would otherwise be possible.

While the embodiments shown in Figs. 1 and 2 have a major loop period that is about four times the period of the minor loop, the periodicity ratio can be increased by the addition of one or more folded portions to the minor loops.

CLAIMS

1.    An ion-implanted contiguous-disk bubble device comprising a write major loop (12) and a minor loop (18A) characterised in that said minor loop includes propagation sections and a folded end portion (22A) in spaced relation to said major loop and wherein bubbles transfer from said major loop (14) to said folded end portion (22A).

2.    A device as claimed in claim 1, including a read major loop and wherein bubbles transfer from a transfer out end portion of the minor loop to said read major loop.

3.    A device as claimed in Claim 1 or 2, wherein said major loop comprises propagation sections having a periodicity that is about four times the periodicity of said minor loop propagation sections.

4.    A device as claimed in any one of claims 1 to 3, including a transfer element positioned in spaced relation to said major loop for receiving bubbles transferring from said major loop to said folded portion.

5.    A device as claimed in claim 4, wherein said transfer element has a merge portion in spaced relation to said folded portion.

6.    A device as claimed in claim 4, wherein said transfer element is connected to said folded portion.

7.    A device as claimed in any of the preceding claims, including a conductor positioned about said major loop.

0078371

FIG.1

FIG.2